# EUROPEAN PATENT SPECIFICATION

(11) **EP 4 295 092 B1**
(45) Date of publication and mention of the grant of the patent: **25.09.2024**
(21) Application number: 21706266.0
(22) Date of filing: 19.02.2021
(51) Int. Cl.: F25B 21/00, H10N 15/10

(54) **ELECTRO-CALORIC OR PYROELECTRIC HEAT EXCHANGER WITH AN IMPROVED HOUSING**
ELEKTROKALORISCHER ODER PYROELEKTRISCHER WÄRMETAUSCHER MIT EINEM VERBESSERTEN GEHÄUSE
ÉCHANGEUR DE CHALEUR ÉLECTROCALORIQUE OU PYROÉLECTRIQUE DOTÉ D'UN BOÎTIER AMÉLIORÉ

(43) Date of publication of application: 27.12.2023
(73) Proprietor: LUXEMBOURG INSTITUTE OF SCIENCE AND TECHNOLOGY (LIST), 4362 Esch-sur-Alzette (LU)
(72) Inventor: DEFAY, Emmanuel, 4362 Esch-sur-Alzette (LU); GERARD, Mathieu, 4362 Esch-sur-Alzette (LU); TORELLÓ MASSANA, Alvar, 4362 Esch-sur-Alzette (LU)
(74) Representative: Lecomte & Partners
(86) International application number: PCT/EP2021/054101
(87) International publication number: WO 2021/123460

(56) References cited:
- RU-C1- 2 079 802
- US-A1- 2010 175 392
- TREVIZOLI P V ET AL: "Thermal-hydraulic evaluation of 3D printed microstructures", APPLIED THERMAL ENGINEERING, PERGAMON, OXFORD, GB, vol. 160, 21 June 2019 (2019-06-21), XP085781790, ISSN: 1359-4311, [retrieved on 20190621], DOI: 10.1016/J.APPLTHERMALENG.2019.113990
- A TURA ET AL: "Experimental performance evaluation of sintered Gd spheres packed beds", INTERNATIONAL CONFERENCE ON MAGNETIC REFRIGERATION AT ROOM TEMPERATURE, 1 January 2016 (2016-01-01), pages 11 - 14, XP055724671, Retrieved from the Internet <URL:https://www.researchgate.net/publication/308740100_EXPERIMENTAL_PERFORMANCE_EVALUATION_OF_SINTERED_Gd_SPHERES_PACKED_BEDS> [retrieved on 20200824], DOI: 10.18462/iir.thermag.2016.0184

## Description

### Technical Field

The invention is directed to the field of heat exchangers using the electro-caloric or pyroelectric effect.

### Background art

The electro-caloric effect is a phenomenon in which a material shows a reversible temperature change under an applied electric field. It is often considered to be the physical inverse of the pyroelectric effect. It should not be confused with the magneto-caloric effect needing a large magnetic field as well as powerful and costly magnets, and also the Thermoelectric effect (specifically, the Peltier effect), in which a temperature difference occurs when a current is driven through an electric junction with two dissimilar conductors. The underlying mechanism of the electro-caloric effect comes from the voltage raising or lowering the entropy of the system.

Prior art patent document published SU 840621 discloses a refrigerating or cold producing device using the electro-caloric effect. The device comprises a central heat exchanger with stacked plates made of electro-caloric material, spaced from each other so as to form between the plates a series of parallel fluid channels. The stack of electro-caloric plates is surrounded by a housing providing two opposed fluid connecting ports. Opposed ends of the electro-caloric plates of the stack are in contact with two electrodes which are connected to an electric power supply. An auxiliary heat exchanger is fluidly connected to each of the two opposed fluid connecting ports. A reciprocating displacement pump is fluidly connected to each of the two auxiliary heat exchanger for moving the fluid from the central heat exchanger to the first auxiliary heat exchanger and from the central heat exchanger to the second auxiliary heat exchanger in a reciprocating manner while the electrodes are powered on and off in an alternating manner.

The functioning principle of the above device is the following. When powering on the electro-caloric plates, the temperature of the latter increases and the fluid is moved from the first auxiliary heat exchanger to the main heat exchanger and is thereby heated. Thereafter the fluid is moved in the opposite direction, i.e. back to the first auxiliary heat exchanger, while the electro-caloric plates are powered off. This means that concomitantly the temperature of the electro-caloric plates decreases due to the heat transfer to the fluid moving to the first heat exchanger and also due to the release of the electric field. Also, still concomitantly, the fluid in the second auxiliary heat exchanger is moved to the main heat exchanger and receives heat therefrom. The fluid is then moved as in the first movement, i.e. back to the second heat exchanger, while the electro-caloric plates are again powered on for the next cycle. The first heat exchanger shows an increasing temperature and can therefore supply heat, i.e. heat a medium, whereas the second heat exchanger shows a decreasing temperature and can therefore receive heat, i.e. cool a medium.

RU2079802C1 discloses a heat exchanger according to the preamble of claim 1 and a method according to the preamble of claim 15.

In the above teaching, the temperature differences achieved in the central heat exchanger are limited, e.g. a few degrees Celsius or Kelvin, and are cyclic. This means that a proper thermal insulation is necessary. The construction of the central heat exchanger in the above teaching shows however a high thermal inertia and poor insulation, thereby reducing the temperature difference achievable.

### Summary of invention

### Technical Problem

The invention has for technical problem to provide an improved heat exchanger with regard to the temperature difference that can be achieved.

### Technical solution

The invention is directed to a heat exchanger comprising at least one substrate made of electro-caloric and/or pyroelectric material and forming at least one channel for a fluid; at least two electrodes at two opposed ends of the at least one substrate; a housing enclosing the at least one substrate and the at least two electrodes, and provided with at least one fluid connecting port; wherein the housing is made of a heat shrinkable flexible tube that is shrunk onto the at least one substrate and forming the at least one fluid connecting port.

The at least one substrate can comprise at least two, preferably at least three, more preferably at least four of the substrates.

According to a preferred embodiment, the heat shrinkable flexible tube tightly fits on the at least one substrate.

According to a preferred embodiment, the at least one channel for the fluid shows a main direction along which the heat shrinkable flexible tube extends.

According to a preferred embodiment, the two ends of the at least one substrate, with the at least two electrodes, are transversal ends.

According to a preferred embodiment, the heat exchanger further comprises: electrical leads connected to the at least two electrodes and extending between at least one outer face of the at least one substrate and an inner face of the heat shrinkable flexible tube.

According to a preferred embodiment, the electrical leads extend out of the shrinkable flexible tube through the at least one fluid connecting port.

According to a preferred embodiment, the heat exchanger further comprises at least one hose inside the at least one fluid connecting port, respectively.

According to a preferred embodiment, the at least one hose is glued to the corresponding fluid connecting port.

The at least one channel can be formed inside the at least one substrate.

According to a preferred embodiment, the at least one substrate comprises a single substrate and spacers are provided on two opposed faces of the single substrate so as to form with the shrinkable flexible tube two of the at least one channel for the fluid.

According to a preferred embodiment, the at least one substrate comprises at least two of said substrates stacked one on the other so as to form between said at least two substrates the at least one channel for the fluid.

According to a preferred embodiment, each of the at least two electrodes is formed by electrically connecting together corresponding ends of the at least two substrates. This can be done by soldering, applying an electrically conductive tape, and/or applying an electrically conductive paste.

According to a preferred embodiment, the at least two substrates are spaced from each other by spacers arranged at the two opposed ends of said at least two substrates.

According to a preferred embodiment, the spacers extend along a main direction of the at least one channel for the fluid.

According to a preferred embodiment, additional spacers are provided on two opposed faces of the stack of the at least two substrates so as to form with the shrinkable flexible tube two of the at least one channel for the fluid.

The invention is also directed to a device for producing heat and/or cold, comprising an electro-caloric heat exchanger with a first fluid connecting port and a second fluid connecting port opposed to said first fluid connecting port; a first auxiliary heat exchanger fluidly connected to the first fluid connecting port; a second auxiliary heat exchanger fluidly connected to the second fluid connecting port; a fluid displacement unit configured for moving the fluid in a reciprocating manner from the electro-caloric heat exchanger to the first auxiliary heat exchanger and from the electro-caloric heat exchanger to the first auxiliary heat exchanger; an electric power supply configured for intermittently powering on and powering off the electro-caloric heat exchanger while the fluid displacement unit moves the fluid in the reciprocating manners so as to; wherein the electro-caloric heat exchanger is according to the invention.

According to a preferred embodiment, the device further comprises a first hose extending inside the first fluid connecting port and fluidly connected to the first auxiliary heat exchanger; and a second hose extending inside the second fluid connecting port and fluidly connected to the second auxiliary heat exchanger.

The invention is also directed a device for producing electrical energy, comprising: a pyroelectric heat exchanger; a heat source; a cold source; a fluid displacement unit configured for moving the fluid in a successive manner from the heat source to the pyroelectric heat exchanger and from the cold source to the pyroelectric heat exchanger; an electric load configured for collecting electrical charges from the pyroelectric heat exchanger while the fluid displacement unit moves the fluid in the successive manner; wherein the pyroelectric heat exchanger is a heat exchanger according to the invention.

The electric load can comprise a capacitor and a power supply configured for applying an electrical field to the capacitor before each movement of the fluid from the heat source to the pyroelectric heat exchanger.

According to a preferred embodiment, the fluid displacement unit comprises a reciprocating pump, and the reciprocating pump, the heat source and the cold source are fluidly connected to each other in series so as to form a sub-circuit that is fluidly connected to a first fluid connecting port of the pyroelectric heat exchanger (6) and to a second fluid connecting port of said pyroelectric heat exchanger, opposed to said first fluid connecting port.

According to a preferred embodiment, the fluid displacement unit comprises a pump, a first selection valve and a second selection valve, the heat source and the cold source being arranged in parallel and fluidly connected to the pyroelectric heat exchanger and the pump via the first and second selection valves so as to form a closed circuit where the fluid circulating through said circuit selectively passes through the heat source or the cold source.

The invention is also directed to a method for manufacturing a heat exchanger, comprising the following steps: (a) providing at least one substrate made of electro-caloric and/or pyroelectric material forming at least one channel for a fluid; (b) forming at least two electrodes at two opposed ends of the at least one substrates; and (c) providing a housing enclosing the at least one substrate and the at least two electrodes, and provided with at least one fluid connecting port; wherein the step (c) comprises inserting the at least one substrate into a heat shrinkable flexible tube and thereafter heating said heat shrinkable flexible tube so as to shrink onto said at least one substrate and form at least one fluid connecting port.

### Advantages of the invention

The invention is particularly interesting in that it substantially reduces the thermal inertia of the heat exchanger, thereby substantially increasing the temperature difference that can be achieved when the heat exchanger is implemented in a device for producing heat and/or cold, as well as in a device for producing electrical energy from heat and cold sources. The inner volume of the heat exchanger shows no dead volume, the plastic material of the heat shrinkable flexible tube forms a first useful thermal insulating barrier, and the mass of said plastic material is very limited. The inventors have indeed found out that the housing of the heat exchanger does not need to support important pressures or forces, so that the present solution is particularly interesting.

### Brief description of the drawings

Figure 1 is a graphic of the temperature and voltage illustrating the principle of the electro-caloric effect.
Figure 2 is a cross-sectional view of a heat exchanger according to the invention.
Figure 3 is a perspective view of the heat exchanger of the invention prior thermal shrinking of the shrinkable flexible tube forming the housing thereof.
Figure 4 is a perspective view of the heat exchanger of the invention integrated in a device for producing heat and/or cold.
Figure 5 a perspective view of the heat exchanger of the invention integrated in a device for producing electrical energy.
Figure 6 a perspective view of the heat exchanger of the invention integrated in a further device for producing electrical energy.

### Description of an embodiment

The electro-caloric effect is an adiabatic and reversible temperature change that occurs in a polar material upon application of an electric field. Large electro-caloric effect can be obtained in ferroelectric materials with perovskite structure since their polarization exhibits great dependency on temperature approaching to the ferroelectric phase transition temperature (Tc) especially with the compositions around the morphotropic phase boundary (MPB). Also, thin films of the material PZT (a mixture of lead, titanium, oxygen and zirconium) show a strong electro-calorific response, with the material cooling down by as much as about 12°C for an electric field change of 480 kV/cm, at an ambient temperature of 220°C.

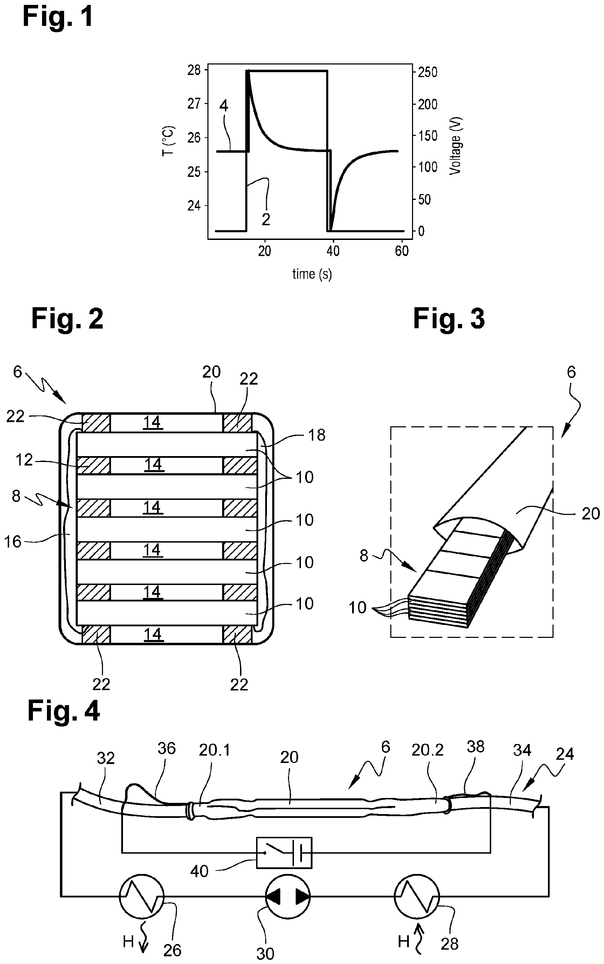

Figure 1 shows graphically the variation over time of the temperature in an electro-caloric material when applying an electric field. The electric field 2 shows a rectangular profile, i.e. is applied with a voltage of 250 Volts during more than 20 seconds. The resulting temperature 4 in the material shows an upper peak with an increase of more than 2°C upon application of the electric field after what the temperature decreases back to its initial value due to material relaxation. The temperature shows then a lower peak, of about the same amplitude as the upper peak, when the electrical field is ceased. The temperature behaviour in the upper and lower peaks is used here as the electro-caloric effect.

Figure 2 is cross-section view of a heat exchanger according to the invention.

The heat exchanger 6 comprises a stack 8 of substrates 10, for instance plates that are spaced from each other by means of spacers 12 for forming fluid channels 14 between the substrates 10. The latter are made of electro-caloric material, like any one of those briefly discussed above or any other known from the skilled person. The fluid channels 14 are parallel and extend along a main direction of the heat exchanger which is perpendicular to the plane of the cross-sectional view. As this is apparent, the spacers 12 are positioned so as to be adjacent to the lateral edges of the substrates 10. The spacers can show adhesive layers for adhering on the substrates 10, thereby enabling to form a stable stack 8 of substrates 10.

Still with reference to figure 2, the lateral ends of the substrates are soldered together on each lateral side, thereby forming the electrodes 16 and 18. An electric voltage can be applied to these electrodes for generating an electric field in each substrate 10. The heat exchanger 6 comprises also a housing formed by a heat shrinkable flexible tube 20 is shrunk onto the stack 8 of substrates 10. Heat-shrink tubing, or commonly, heat shrink or heatshrink, is a shrinkable plastic tube normally used to insulate wires, providing abrasion resistance and environmental protection for stranded and solid wire conductors, connections, joints and terminals in electrical work. It is ordinarily made of polyolefin, which shrinks radially (but not longitudinally) when heated, to between one-half and one-sixth of its diameter. The heat shrinkable flexible tube 20, in its shrunk state as illustrated in figure 2, tightly fits on the stack 8 of substrates 10, so the fluid channels 14 between the substrates 10 are the only possible flow channels along the heat exchanger 6.

As this is apparent in figure 2, additional spacers 22 can be provided on the outer opposed faces of the stack 8 of substrates 10, more specifically on the outer faces of the external substrates of the stack 8 of substrates 10, so as to form fluid channels 14 between the outer face each of these two substrates and the inner corresponding face of the heat shrinkable flexible tube 20. The additional spacers 22 are also adjacent to the lateral edges of the corresponding substrates 10.

In alternative to the above described stack of substrates 10, the substrate can be single and form fluid channel(s) either internally, i.e. inside the substrate, and/or with spacers on the outer opposed faces of the substrate like the above spacers 22.

The heat shrinkable flexible tube 20 is black but can be of different colours.

Figure 3 is a perspective view of the heat exchanger 6 according to the invention where however the heat shrinkable flexible tube 20 is not yet shrunk. We can observe that the heat shrinkable flexible tube 20 shows an inner circumference that is substantially larger than the outer circumference of the stack 8 of substrates 10. This allows the stack 8 of substrates 10 to be easily inserted into the heat shrinkable flexible tube 20. Thereafter the heat shrinkable flexible tube 20 is heated and shrinks onto the stack 8 of substrates 10 for arriving at a tight fit as illustrated in figure 2.

As this is apparent in figure 3, the substrates 10 can extend along a main direction corresponding to the main direction of the heat exchanger 6 and of the heat shrinkable flexible tube 20, while each substrate 10 can show a series of sub-sections adjacent next to each other along that main direction.

A method of manufacturing the heat exchanger, can comprise the following steps:
(a) stacking the substrates one on the other, preferably by means of the spacers, so as to form between them the fluid channels;
(b) forming the electrodes at the two opposed ends of the substrates and connecting the electrical leads thereto; and
(c) inserting the stack of the substrates with the electrical leads into the heat shrinkable flexible tube and thereafter heating said heat shrinkable flexible tube so as to shrink onto said stack and form the fluid connecting ports.

The above detailed construction is advantageous in that there is no dead volume in the passage for the fluid and in that the wall of the heat shrinkable flexible tube provides a good first thermal insulation barrier in comparison with most of the current materials used for forming a housing, like metal based materials. The generally cylindrical outer form of the heat exchanger allows it to be easily surrounded by one or several insulation covers. In that case, the thermal inertia of the heat exchanger is limited to the electro-caloric substrates and the heat shrinkable flexible tube whereas the latter shows a reduced mass.

Figure 4 illustrates the heat exchanger of the invention integrated into a device for producing heat and/or cold.

The device 24 comprises, essentially, the heat exchanger 6 as in figures 2 and 3 and the above description, a first auxiliary heat exchanger 26 fluidly connected to a first fluid connecting port 20.1 of the heat exchanger 6, a second auxiliary heat exchanger 28 fluidly connected to a second fluid connecting port 20.2 of the heat exchanger 6, and a fluid displacement unit 30 fluidly interconnecting the first and second auxiliary heat exchangers 26 and 28, and configured for moving the fluid in two opposed direction, in a reciprocating manner. For instance, each of the first and second fluid connecting ports 20.1 and 20.2 is formed by the heat shrinkable flexible tube 20. The first auxiliary heat exchanger 26 is fluidly connected to the heat exchanger 6 by a first hose 32 that is inserted into the first fluid connecting port 20.1 on a corresponding end of the heat shrinkable flexible tube 20 that once shrunk onto said hose 32 forms a tight connection. Similarly, the second auxiliary heat exchanger 28 is fluidly connected to the heat exchanger 6 by a second hose 34 that is inserted into the second fluid connecting port 20.2 on the other and corresponding end of the heat shrinkable flexible tube 20 that once shrunk onto said hose 34 forms a tight connection. Glue or any other kind of sealant can be applied for increasing the mechanical strength and/or fluid tightness of the connection.

Two electrical leads or wires 36 and 38 are connected to the electrodes (not visible in figure 4 but well in figure 2 at references 16 and 18) and extend along the main direction of the heat exchanger and through the first and second fluid connecting ports 20.1 and 20.2. More specifically, each electrical lead 36 and 38 extends between one of the fluid connecting ports 20.1/20.2 and the corresponding hose 32/34. The electrical leads 36 and 38 are connected to an electric power source 40 that is switchable, i.e. so that the electro-caloric substrates can be selectively powered on and off.

The operation of the device in figure 4 is as follows. In a first cycle, the electric power source 40 is switched on for powering on the electro-caloric substrates, leading to a rapid increase of the temperature of said substrates. Heat is then transferred from said substrates to the fluid. Concomitantly, the fluid displacement unit 30 is operated for moving the fluid from the heat exchanger 6 to the first auxiliary heat exchanger 26, thereby bringing heat to said auxiliary heat exchanger. In the same time fluid from the second auxiliary heat exchanger has moved to the heat exchanger 6 while, or after what, the electric power source 40 is switched off, leading to a temperature decrease in the substrates. Heat is then transferred from the fluid (originating from the second auxiliary heat exchanger) to the substrates. Said differently, the fluid from the second auxiliary heat exchanger 28 that moved to the heat exchanger 6 is cooled down. A second cycle identical to the first one can then take place, and so on in a reciprocating manner.

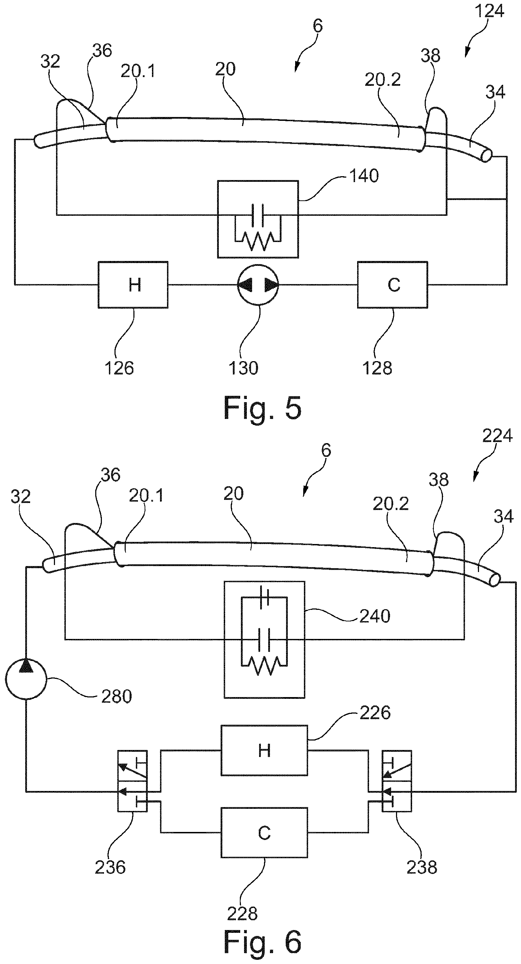

Figures 5 and 6 show two devices for producing electrical energy using the heat exchanger of the invention, the heat exchanger being in that case a pyroelectric heat exchanger.

The pyroelectric effect is the ability of certain materials to generate a temporary voltage when they are heated or cooled. The change in temperature modifies the positions of the atoms slightly within the crystal structure, such that the polarization of the material changes. This polarization change gives rise to a voltage across the crystal. The pyroelectric effect can generally be considered as the physical inverse of the electro-caloric effect. This means that the above-described electro-caloric heat exchanger can be used as a pyroelectric heat exchanger, and vice versa.

The device 124 is very similar to the device 24 of figure 4. It is therefore referred to the detailed description of figure 4. The device 124 differs from the device 24 in figure 4 essentially in that the electrical power source is replaced by an electrical load 140 and in that the auxiliary heat exchangers are replaced by a heat source 126 and a cold source 128. Important is however to note that in practice, the heat source 126 can comprise an auxiliary heat exchanger receiving heat, or a heat reservoir. Similarly, the cold source can comprise an auxiliary heat exchanger dissipating heat, or a cold reservoir.

In operation, the fluid displacement unit 130, that can be a reciprocating pump, moves the fluid from the heat source 126 to the heat exchanger 6, leading to an increase of temperature of the electro-caloric/pyroelectric substrates in said heat exchanger 6, thereby producing an electrical voltage that charges the electrical load 140. The latter is represented as comprising a capacitor, being understood that such an electrical load can be substantially more sophisticated, e.g. by comprising diodes or switching means for controlling the electrical charge during that cycle and the discharge during the next cycle. During that first cycle, the fluid initially contacting the electro-caloric/pyroelectric substrates is moved towards the cold source 128. During the second cycle, the fluid is moved in the opposed direction, i.e. from the cold source 128 to the heat exchanger 6, leading to a lowering of the temperature of the electro-caloric/pyroelectric substrates in the heat exchanger 6. The electrical load is configured to keeping its electrical charge or to transmit it to an electrical consumer connected thereto. In the next third cycle, identical to the first one, the fluid is moved from the heat source 126 to the heat exchanger 6, thereby further electrically charging the electrical load 140.

The thermodynamic cycle described here above is a Stirling thermodynamic cycle.

The device 224 in figure 6 works on the same principle as the device 124 in figure 5 where however the fluid instead of being moved in a reciprocal manner, is moved in the same direction but by passing in an alternating manner through the heat source and the cold source, in order to generate in the electro-caloric substrates successive temperature increases and temperature decreases which produce successive electrical field increases and decreases, resulting in a pulsed electrical power signal. In addition, an external electrical field is applied to the capacitor in an intermittent fashion during before heating.

The fluid displacement unit comprises a pump 230 and selection valves 236 and 238 which are designed for selectively allowing the fluid flow to pass through the heat source 226 or the cold source 228. While the pump 230 circulates the fluid in the same direction, the valves 236 and 238 are operated in a successive manner so as to successively allow the fluid to pass through the heat source 226 or the cold source 228 in an alternating manner. The valves 236 and 238 can be three-way valves with two positions that selectively fluidly connects one of two ports to a third port, the two ports being fluidly connected to the heat and cold sources and the third port being fluidly connected to the heat exchanger 6. Such valves are well known and widely commercially available.

The resulting pulsed electrical power signal is similar to the one of the device 124 of figure 5.

The electrical load 240 is however somehow different from the electrical load 140 of the device 124 of figure 5 in that a power supply is present for applying in an intermittent fashion a voltage to the capacitor, before each heating recurrent step.

The thermodynamic cycle described here above is an Olsen thermodynamic cycle.

## Claims

1. Heat exchanger (6) comprising:
- at least one substrate (10) made of electro-caloric or pyroelectric material and forming at least one channel (14) for a fluid;
- at least two electrodes (16, 18) at two opposed ends of the at least one substrate (10);
- a housing (20) enclosing the at least one substrate (10) and the at least two electrodes (16, 18), and provided with at least one fluid connecting port (20.1, 20.2);
**characterized in that**
the housing is made of a heat shrinkable flexible tube (20) that is shrunk onto the at least one substrate (10) and forming the at least one fluid connecting port (20.1, 20.2).

2. Heat exchanger (6) according to claim 1, wherein the heat shrinkable flexible tube (20) tightly fits on the at least one substrate (10).

3. Heat exchanger (6) according to one of claims 1 and 2, wherein the at least one channel (14) for the fluid shows a main direction along which the heat shrinkable flexible tube (20) extends, preferably wherein the two ends of the at least one substrate (10), with the at least two electrodes (16, 18), are transversal ends.

4. Heat exchanger (6) according to any one of claims 1 to 3, further comprising:
- electrical leads (36, 38) connected to the at least two electrodes (16, 18) and extending between at least one outer face of the at least one substrate (10) and an inner face of the heat shrinkable flexible tube (20),
preferably wherein the electrical leads (36, 38) extend out of the shrinkable flexible tube (20) through the at least one fluid connecting port (20.1, 20.2).

5. Heat exchanger (6) according to any one of claims 1 to 4, further comprising:
- at least one hose (32, 34) inside the at least one fluid connecting port (20.1, 20.2), respectively,
preferably wherein the at least one hose (32, 34) is glued to the corresponding fluid connecting port (20.1, 20.2).

6. Heat exchanger (6) according to any one of claims 1 to 5, wherein the at least one substrate (10) comprises a single substrate (10), and spacers (22) are provided on two opposed faces of the single substrate (10) so as to form with the shrinkable flexible tube (20) two of the at least one channel (14) for the fluid.

7. Heat exchanger (6) according to any one of claims 1 to 6, wherein the at least one substrate (10) comprises at least two of said substrates (10) stacked one on the other so as to form between said at least two substrates the at least one channel for a fluid (14), preferably wherein each of the at least two electrodes (16, 18) is formed by electrically connecting together corresponding ends of the at least two substrates (10).

8. Heat exchanger (6) according to claim 7, wherein the at least two substrates (10) are spaced from each other by spacers (12) arranged at the two opposed ends of said at least two substrates (10), preferably wherein the spacers (12) extend along a main direction of the at least one channel (14) for the fluid.

9. Heat exchanger (6) according to claim 8, wherein additional spacers (22) are provided on two opposed faces of the stack (8) of the at least two substrates (10) so as to form with the shrinkable flexible tube (20) two of the at least one channel (14) for the fluid.

10. Device (24) for producing heat and/or cold, comprising:
- an electro-caloric heat exchanger (6) with a first fluid connecting port (20.1) and a second fluid connecting port (20.2) opposed to said first fluid connecting port (20.1);
- a first auxiliary heat exchanger (26) fluidly connected to the first fluid connecting port (20.1);
- a second auxiliary heat exchanger (28) fluidly connected to the second fluid connecting port (20.2);
- a fluid displacement unit (30) configured for moving the fluid in a reciprocating manner from the electro-caloric heat exchanger (6) to the first auxiliary heat exchanger (26) and from the electro-caloric heat exchanger (6) to the first auxiliary heat exchanger (26);
- an electric power supply (40) configured for intermittently powering on and powering off the electro-caloric heat exchanger (6) while the fluid displacement unit (30) moves the fluid in the reciprocating manners;
**characterized in that**
the electro-caloric heat exchanger (6) is according to any one of claims 1 to 9.

11. Device (24) according to claim 10, wherein the at least one hose (32, 34), if present, otherwise said device (24) comprises:
- a first hose (32) extending inside the first fluid connecting port (20.1) and fluidly connected to the first auxiliary heat exchanger (26); and
- a second hose (34) extending inside the second fluid connecting port (20.2) and fluidly connected to the second auxiliary heat exchanger (28).

12. Device (124; 224) for producing electrical energy, comprising:
- a pyroelectric heat exchanger (6);
- a heat source (126; 226);
- a cold source (128; 228);
- a fluid displacement unit (130; 230, 236, 238) configured for moving the fluid in a successive manner from the heat source (126; 226) to the pyroelectric heat exchanger (6) and from the cold source (128; 228) to the pyroelectric heat exchanger (6);
- an electric load (140; 240) configured for collecting electrical charges from the pyroelectric heat exchanger (6) while the fluid displacement unit (130; 230, 236, 238) moves the fluid in the successive manner;
**characterized in that**
the pyroelectric heat exchanger (6) is according to any one of claims 1 to 9.

13. Device (124) according to claim 12, wherein the fluid displacement unit comprises a reciprocating pump (130), and the reciprocating pump (130), the heat source (126) and the cold source (128) are fluidly connected to each other in series so as to form a sub-circuit that is fluidly connected to a first fluid connecting port (20.1) of the pyroelectric heat exchanger (6) and to a second fluid connecting port (20.2) of said pyroelectric heat exchanger (6), opposed to said first fluid connecting port (20.1).

14. Device (224) according to claim 12, wherein the fluid displacement unit comprises a pump (230), a first selection valve (236) and a second selection valve (238), the heat source (226) and the cold source (228) being arranged in parallel and fluidly connected to the pyroelectric heat exchanger (6) and the pump (230) via the first and second selection valves (236; 238) so as to form a closed circuit where the fluid circulating through said circuit selectively passes through the heat source (226) or the cold source (228).

15. Method for manufacturing a heat exchanger (6), comprising the following steps:
(a) providing at least one substrate (10) made of electro-caloric or pyroelectric material and forming at least one channel (14) for a fluid;
(b)forming at least two electrodes (16, 18) at two opposed ends of the at least one substrate (10); and
(c) providing a housing (20) enclosing the at least one substrate (10) and the at least two electrodes (16, 18), and provided with at least one fluid connecting port (20.2, 20.2);
**characterized in that**
the step (c) comprises inserting the at least one substrate (10) into a heat shrinkable flexible tube (20) and thereafter heating said heat shrinkable flexible tube (20) so as to shrink onto said at least one substrate (10) and form at least one fluid connecting port (20.1, 20.2).

## Patentansprüche

1. Wärmetauscher (6), der Folgendes umfasst:
- mindestens ein Substrat (10) aus elektrokalorischem oder pyroelektrischem Material, das mindestens einen Kanal (14) für ein Fluid bildet:
- mindestens zwei Elektroden (16, 18) an zwei gegenüberliegenden Enden des mindestens einen Substrats (10);
- ein Gehäuse (20), das das mindestens eine Substrat (10) und die mindestens zwei Elektroden (16, 18) umschließt und mit mindestens einer Fluidanschlussöffnung (20.1, 20.2) versehen ist;
**dadurch gekennzeichnet, dass**
das Gehäuse aus einem wärmeschrumpfbaren flexiblen Schlauch (20) besteht, der auf das mindestens eine Substrat (10) aufgeschrumpft ist und die mindestens eine Flüssigkeitsanschlussöffnung (20.1, 20.2) bildet.

2. Wärmetauscher (6) nach Anspruch 1, wobei der wärmeschrumpfende flexible Schlauch (20) fest auf dem mindestens einen Substrat (10) sitzt.

3. Wärmetauscher (6) nach einem der Ansprüche 1 und 2, wobei der mindestens eine Kanal (14) für das Fluid eine Hauptrichtung aufweist, entlang derer sich der wärmeschrumpfende flexible Schlauch (20) erstreckt, wobei vorzugsweise die beiden Enden des mindestens einen Substrats (10) mit den mindestens zwei Elektroden (16, 18) transversale Enden sind.

4. Wärmetauscher (6) nach einem der Ansprüche 1 bis 3, ferner umfassend:
- elektrische Leitungen (36, 38), die mit den mindestens zwei Elektroden (16, 18) verbunden sind und sich zwischen mindestens einer Außenfläche des mindestens einen Substrats (10) und einer Innenfläche des wärmeschrumpfenden flexiblen Schlauchs (20) erstrecken, wobei sich die elektrischen Leitungen (36, 38) vorzugsweise durch die mindestens eine Fluidanschlussöffnung (20.1, 20.2) aus dem schrumpfenden flexiblen Schlauch (20) heraus erstrecken.

5. Wärmetauscher (6) nach einem der Ansprüche 1 bis 4, ferner umfassend:
- mindestens einen Schlauch (32, 34) innerhalb der mindestens einen Fluidanschlussöffnung (20.1, 20.2),
wobei der mindestens eine Schlauch (32, 34) vorzugsweise mit der entsprechenden Fluidanschlussöffnung (20.1, 20.2) verklebt ist.

6. Wärmetauscher (6) nach einem der Ansprüche 1 bis 5, wobei das mindestens eine Substrat (10) ein einziges Substrat (10) umfasst und Abstandshalter (22) auf zwei gegenüberliegenden Seiten des einzigen Substrats (10) vorgesehen sind, um mit dem schrumpfbaren flexiblen Schlauch (20) zwei der mindestens einen Kanäle (14) für das Fluid zu bilden.

7. Wärmetauscher (6) nach einem der Ansprüche 1 bis 6, wobei das mindestens eine Substrat (10) mindestens zwei der Substrate (10) umfasst, die übereinander gestapelt sind, um zwischen den mindestens zwei Substraten den mindestens einen Kanal für ein Fluid (14) zu bilden, wobei vorzugsweise jede der mindestens zwei Elektroden (16, 18) durch elektrisches Verbinden entsprechender Enden der mindestens zwei Substrate (10) gebildet wird.

8. Wärmetauscher (6) nach Anspruch 7, wobei die mindestens zwei Substrate (10) durch Abstandshalter (12) voneinander getrennt sind, die an den beiden gegenüberliegenden Enden der mindestens zwei Substrate (10) angeordnet sind, wobei sich die Abstandshalter (12) vorzugsweise entlang einer Hauptrichtung des mindestens einen Kanals (14) für das Fluid erstrecken.

9. Wärmetauscher (6) nach Anspruch 8, wobei zusätzliche Abstandshalter (22) auf zwei gegenüberliegenden Seiten des Stapels (8) der mindestens zwei Substrate (10) vorgesehen sind, um mit dem schrumpfbaren flexiblen Schlauch (20) zwei der mindestens einen Kanäle (14) für das Fluid zu bilden.

10. Vorrichtung (24) zur Erzeugung von Wärme und/oder Kälte, die Folgendes umfasst:
- einen elektrokalorischen Wärmetauscher (6) mit einer ersten Fluidanschlussöffnung (20.1) und einer zweiten Fluidanschlussöffnung (20.2), die der ersten Fluidanschlussöffnung (20.1) gegenüberliegt;
- einen ersten Hilfswärmetauscher (26), der mit der ersten Fluidanschlussöffnung (20.1) verbunden ist;
- einen zweiten Hilfswärmetauscher (28), der mit der zweiten Fluidverbindungsöffnung (20.2) in Fluidverbindung steht;
- eine Fluidverdrängungseinheit (30), die so ausgelegt ist, dass sie das Fluid in einer wechselseitigen Weise von dem elektrokalorischen Wärmetauscher (6) zu dem ersten Hilfswärmetauscher (26) und von dem elektrokalorischen Wärmetauscher (6) zu dem ersten Hilfswärmetauscher (26) bewegt;
- eine elektrische Stromversorgung (40), die so gestaltet ist, dass sie den elektrokalorischen Wärmetauscher (6) intermittierend ein- und ausschaltet, während die Fluidverdrängungseinheit (30) das Fluid in der Hin- und Herbewegung bewegt;
**dadurch gekennzeichnet, dass**
der elektrokalorische Wärmetauscher (6) nach einem der Ansprüche 1 bis 9 ausgeführt ist.

11. Vorrichtung (24) nach Anspruch 10, wobei der mindestens eine Schlauch (32, 34), falls vorhanden, ansonsten die Vorrichtung (24) Folgendes umfasst:
- einen ersten Schlauch (32), der sich innerhalb der ersten Fluidanschlussöffnung (20.1) erstreckt und mit dem ersten Hilfswärmetauscher (26) fluidisch verbunden ist; und
- einen zweiten Schlauch (34), der sich innerhalb des zweiten Fluidanschlusses (20.2) erstreckt und mit dem zweiten Zusatzwärmetauscher (28) verbunden ist.

12. Vorrichtung (124; 224) zur Erzeugung elektrischer Energie, die Folgendes umfasst:
- einen pyroelektrischen Wärmetauscher (6);
- eine Wärmequelle (126; 226);
- eine Kältequelle (128; 228):
- eine Fluidverdrängungseinheit (130; 230, 236, 238), die so gestaltet ist, dass sie das Fluid nacheinander von der Wärmequelle (126; 226) zu dem pyroelektrischen Wärmetauscher (6) und von der Kältequelle (128; 228) zu dem pyroelektrischen Wärmetauscher (6) bewegt:
- eine elektrische Last (140; 240), die so gestaltet ist, dass sie elektrische Ladungen von dem pyroelektrischen Wärmetauscher (6) aufnimmt, während die Fluidverdrängungseinheit (130; 230, 236, 238) das Fluid in der aufeinander folgenden Weise bewegt;
**dadurch gekennzeichnet, dass** der pyroelektrische Wärmetauscher (6) nach einem der Ansprüche 1 bis 9 ausgeführt ist.

13. Vorrichtung (124) nach Anspruch 12, wobei die Fluidverdrängungseinheit eine Hubkolbenpumpe (130) umfasst und die Hubkolbenpumpe (130), die Wärmequelle (126) und die Kältequelle (128) strömungstechnisch miteinander in Reihe geschaltet sind, um einen Teilkreislauf zu bilden, der strömungstechnisch mit einer ersten Fluidanschlussöffnung (20.1) des pyroelektrischen Wärmetauschers (6) und mit einer zweiten Fluidanschlussöffnung (20.2) des pyroelektrischen Wärmetauschers (6) verbunden ist, die der ersten Fluidanschlussöffnung (20.1) gegenüberliegt.

14. Vorrichtung (224) nach Anspruch 12, wobei die Fluidverdrängungseinheit eine Pumpe (230), ein erstes Auswahlventil (236) und ein zweites Auswahlventil (238) umfasst, wobei die Wärmequelle (226) und die Kältequelle (228) parallel angeordnet und über das erste und das zweite Auswahlventil (236; 238) mit dem pyroelektrischen Wärmetauscher (6) und der Pumpe (230) fluidmäßig verbunden sind, um einen geschlossenen Kreislauf zu bilden, in dem das durch den Kreislauf fließende Fluid selektiv durch die Wärmequelle (226) oder die Kältequelle (228) fließt.

15. Verfahren zur Herstellung eines Wärmetauschers (6), das die folgenden Schritte umfasst:
(a) Bereitstellen mindestens eines Substrats (10) aus elektrokalorischem oder pyroelektrischem Material und Bilden mindestens eines Kanals (14) für ein Fluid;
(b) Ausbilden von mindestens zwei Elektroden (16, 18) an zwei gegenüberliegenden Enden des mindestens einen Substrats (10); und
(c) Bereitstellen eines Gehäuses (20), das das mindestens eine Substrat (10) und die mindestens zwei Elektroden (16, 18) umschließt und mit mindestens einer Fluidanschlussöffnung (20.2, 20.2) versehen ist;
**dadurch gekennzeichnet, dass** der Schritt (c) das Einsetzen des mindestens einen Substrats (10) in einen wärmeschrumpfenden flexiblen Schlauch (20) und das anschließende Erhitzen des wärmeschrumpfenden flexiblen Schlauchs (20) umfasst, um auf das mindestens eine Substrat (10) zu schrumpfen und mindestens eine Fluidanschlussöffnung (20.1, 20.2) zu bilden.

## Revendications

1. Échangeur de chaleur (6) comprenant :
- au moins un substrat (10) fait de matériau électro-calorique et formant au moins un canal (14) pour un fluide;
- au moins deux électrodes (16, 18) à deux extrémités opposées de l'au moins un substrat (10);
- un boîtier (20) renfermant l'au moins un substrat (10) et les au moins deux électrodes (16, 18), et muni d'au moins un port de raccordement de fluide (20.1, 20.2);
**caractérisé en ce que**
le boîtier est fait d'un tube thermo-rétractable flexible (20) qui est rétracté sur l'au moins un substrat (10) et formant l'au moins un port de raccordement de fluide (20.1, 20.2).

2. Échangeur de chaleur (6) selon la revendication 1, dans lequel le tube thermo rétractable flexible (20) épouse étroitement l'au moins un substrat (10).

3. Échangeur de chaleur (6) selon l'une des revendications 1 et 2, dans lequel l'au moins un canal (14) pour le fluide présente une direction principale le long de laquelle le tube thermo-rétractable flexible (20) s'étend, préférentiellement les deux extrémités de l'au moins un substrat (10), avec les au moins deux électrodes (16, 18), sont des extrémités transversales.

4. Échangeur de chaleur (6) selon l'une quelconque des revendications 1 à 3, comprenant en outre :
- des fils électriques (36, 38) connectés aux au moins deux électrodes (16, 18) et s'étendant entre au moins une face externe de l'au moins un substrat (10) et une face interne du tube thermo-rétractable flexible (20),
préférentiellement les fils électriques (36, 38) s'étendent hors du tube thermo-rétractable flexible (20) à travers l'au moins un port de raccordement de fluide (20.1, 20.2).

5. Échangeur de chaleur (6) selon l'une quelconque des revendications 1 à 4, comprenant, en outre :
- au moins un tuyau flexible (32, 34) à l'intérieur de l'au moins un port de raccordement de fluide (20.1, 20.2), respectivement,
préférentiellement l'au moins un tuyau flexible (32, 34) est collé au port de raccordement de fluide correspondant (20.1, 20.2).

6. Échangeur de chaleur (6) selon l'une quelconque des revendications 1 à 5, dans lequel l'au moins un substrat (10) comprend un substrat unique (10), et des entretoises (22) sont disposées sur deux faces opposées du substrat unique (10) de manière à former avec le tube rétractable flexible (20) deux de l'au moins un canal (14) pour le fluide.

7. Échangeur de chaleur (6) selon l'une quelconque des revendications 1 à 6, dans lequel l'au moins un substrat (10) comprend au moins deux desdits substrats (10) empilés l'un sur l'autre de manière à former, entre lesdits au moins deux substrats, l'au moins un canal pour un fluide (14), préférentillement dans lequel chacune des au moins deux électrodes (16, 18) est formée en connectant électriquement ensemble des extrémités correspondantes des au moins deux substrats (10).

8. Échangeur de chaleur (6) selon la revendication 7, dans lequel les au moins deux substrats (10) sont espacés l'un de l'autre par des entretoises (12) disposées aux deux extrémités opposées desdits au moins deux substrats (10), préférentiellement dans lequel les entretoises (12) s'étendent le long d'une direction principale de l'au moins un canal (14) pour le fluide.

9. Échangeur de chaleur (6) selon la revendication 8, dans lequel des entretoises supplémentaires (22) sont fournies sur les deux faces opposées de la pile (8) des au moins deux substrats (10) de manière à former avec le tube rétractable flexible (20) deux de l'au moins un canal (14) pour le fluide.

10. Appareil (24) pour produire de la chaleur et/ou du froid, comprenant :
- un échangeur de chaleur électro-calorique (6) avec un premier port de raccordement de fluide (20.1) et un deuxième port de raccordement de fluide (20.2) opposé audit premier port de raccordement de fluide (20.1);
- un premier échangeur de chaleur auxiliaire (26) raccordé fluidiquement au premier port de raccordement de fluide (20.1);
- un deuxième échangeur de chaleur auxiliaire (28) raccordé fluidiquement au deuxième port de raccordement de fluide (20.2);
- une unité de déplacement de fluide (30) configurée pour déplacer le fluide de manière réciproque de l'échangeur de chaleur électro-calorique (6) vers le premier échangeur de chaleur auxiliaire (26) et de l'échangeur de chaleur électro-calorique (6) vers le deuxième échangeur de chaleur auxiliaire (26);
- une alimentation en énergie électrique (40) configurée pour mettre sous tension et mettre hors tension de manière intermittente l'échangeur de chaleur électro-calorique (6) pendant que l'unité de déplacement de fluide (30) déplace les fluides de manière réciproque;
**caractérisé en ce que**
l'échangeur de chaleur électro-calorique (6) est selon l'une quelconque des revendications 1 à 9.

11. Appareil (24) selon la revendication 10, comprenant en outre :
- un premier tuyau (36) s'étendant à l'intérieur du premier port de raccordement de fluide (20.1) et raccordé fluidiquiement au premier échangeur de chaleur auxiliaire (26); et
- un deuxième tuyau (38) s'étendant à l'intérieur du deuxième port de raccordement de fluide (20.2) et raccordé fluidiquement au deuxième échangeur de chaleur auxiliaire (28).

12. Appareil (124 ; 224) pour produire de l'énergie électrique, comprenant :
- un échangeur de chaleur électro-calorique (6);
- une source de chaleur (126 ; 226) ;
- une source de froid (128 ; 228) ;
- une unité de déplacement de fluide (130 ; 230 ; 236 ; 238) configurée pour déplacer le fluide de manière successive de la source de chaleur (126 ; 226) à l'échangeur de chaleur électro-calorique (6) et de la source de froid (128 ; 228) à l'échangeur de chaleur électro-calorique (6);
- une charge électrique (140 ; 240) configurée pour collecter des charges électriques de l'échangeur de chaleur électro-calorique (6) pendant que l'unité de déplacement de fluide (130 ; 230 ; 236 ; 238) déplace le fluide de manière successive;
**caractérisé en ce que**
l'échangeur de chaleur électro-calorique (6) est selon l'une quelconque des revendications 1 à 9.

13. Appareil (124) selon la revendication 12, dans lequel l'unité de déplacement de fluide (130) comprend une pompe à mouvement alternatif (130), et la pompe à mouvement alternatif (130), la source de chaleur (126) et la source de froid (128) sont connectées fluidiquement entre elles en série de manière à former un sous-circuit qui est connecté fluidiquement à un premier port de raccordement de fluide (20.1) de l'échangeur de chaleur électro-calorique (6) et à un deuxième port de raccordement de fluide (20.2) de l'échangeur de chaleur électro-calorique (6), opposé au premier port de raccordement (20.1).

14. Appareil (224) selon la revendication 12, dans lequel l'unité de déplacement de fluide (230) comprend une pompe (230), une première vanne de sélection (236) et une deuxième vanne de sélection (238), la source de chaleur (226) et la source de froid (238) étant disposées en parallèle et connectées fluidiquement à l'échangeur de chaleur électro-calorique (6) et la pompe (230) via les première et deuxième vannes de sélection (236 ; 238) de manière à former un circuit fermé où le fluide circulant dans le circuit passe de manière sélective au travers de la source de chaleur (226) ou la source de froid (228).

15. Méthode de fabrication d'un échangeur de chaleur électro-calorique (6), comprenant les étapes suivantes :
(a)fournir au moins un substrat (10) fait de matériau électro-calorique et formant au moins un canal (14) pour un fluide ;
(b) former au moins deux électrodes (16, 18) à deux extrémités opposées de l'au moins un substrat (10); et
(c) fournir un boîtier (20) renfermant l'au moins un substrat (10) et les au moins deux électrodes (16, 18), et doté d'au moins un port de raccordement de fluide (20.2, 20.2);
**caractérisée en ce que**
l'étape (c) comprend l'insertion de l'au moins un substrat (10) dans un tube thermo-rétractable flexible (20) et ensuite le chauffage dudit tube thermo-rétractable flexible (20) de manière à rétracter sur ledit au moins un substrat (10) et former au moins un port de raccordement de fluide (20.1, 20.2).
